Europäisches Patentamt

European Patent Office

Office européen des brevets

(19)

(11) Publication number: **0 049 039**
**B1**

(12)

# EUROPEAN PATENT SPECIFICATION

(45) Date of publication of patent specification: **11.07.84**

(51) Int. Cl.³: **G 06 F 15/347, G 06 F 5/00**

(21) Application number: **81303689.4**

(22) Date of filing: **13.08.81**

(54) **Data processing apparatus for processing sparse vectors.**

(30) Priority: **29.09.80 US 191808**

(43) Date of publication of application:
**07.04.82 Bulletin 82/14**

(45) Publication of the grant of the patent:
**11.07.84 Bulletin 84/28**

(84) Designated Contracting States:
**DE FR GB**

(56) References cited:
**US - A - 3 919 534**

**IEEE TRANSACTIONS ON COMPUTERS, vol. C-19, no. 9, September 1970 New York, US KUCK: "A preprocessing highspeed memory system", pages 793-802**

(73) Proprietor: **CONTROL DATA CORPORATION**
**8100-34th Avenue South**
**Minneapolis Minnesota 55440 (US)**

(72) Inventor: **Kort, Raymond Clarence**
**215-17th Avenue Northwest**
**New Brighton Minnesota 55112 (US)**
Inventor: **Kelley, James Walter**
**Route No. 1**
**Stacy Minnesota (US)**

(74) Representative: **Caro, William Egerton et al,**
**J. MILLER & CO. Lincoln House 296-302 High Holborn**
**London WC1V 7JH (GB)**

Courier Press, Leamington Spa, England.

## Description

This invention relates to data processing apparatus as set out in the first portion of claim 1.

Sparse vectors are multi-operand vectors having zero or near zero operands removed and the remaining operands packed together. An apparatus for processing such vectors by a central processing unit of a data processing apparatus is disclosed in US—A—3 919 534. Such apparatus forwards operands to an arithmetic logic unit (ALU) from a given sparse vector one at a time. Zero operands are provided to the ALU only when a second sparse vector being input to the ALU for coprocessing has a non-zero operand in that order. An order vector is provided for each sparse vector to indicate by the state of a bit whether the correspondingly ordered sparse vector operand is zero or non-zero. There are means to align and order said forwarded operands according to the alignment and order of the order vector bits before the operands are sent to the arithmetic logic unit in tandem. An order vector is essentially inspected one bit at a time.

IEEE Transactions on Computers, vol. C—19, number 9, Sept. 1970, pp 793—802 describes a data processing apparatus that treats order vector bits (tag words) and sparse vector operands in groups (partitions), aligns non-zero operand pairs according to the order vectors and forwards them in tandem to an arithmetic unit. A detailed solution as to how this can be done quickly is not disclosed therein.

The invention as claimed is intended to solve the problem of how to design a data processsing apparatus which quickly treats sparse vectors and order vectors in groups.

The invention is illustrated merely by way of example, in the accompanying drawings, in which:-

Fig. 1 is a schematic circuit diagram illustrating expansion of a sparse vector for tandem processing by an ALU in a data processing apparatus according to the present invention; and

Fig. 2 is a schematic circuit diagram illustrating compression of tandem resultants from an ALU into a sparse vector in a data processing apparatus according to the present invention.

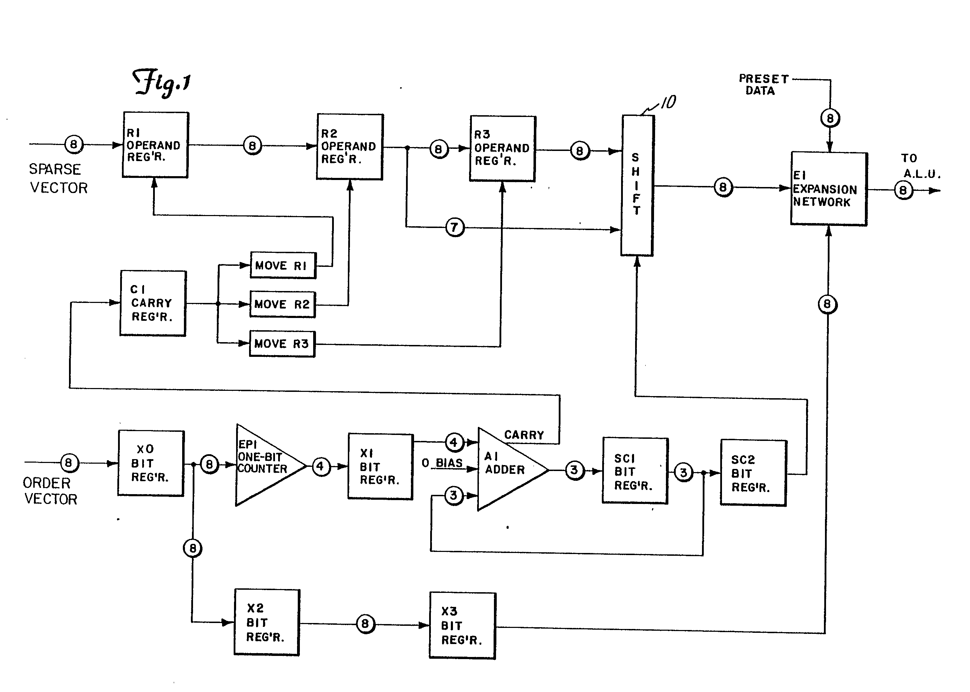

Fig. 1 illustrates expansion of a sparse vector for tandem processing by an arithmetic logic unit (ALU) in a data processing apparatus according to the present invention. Normally, the ALU will coprocess two vectors at a time: adding, subtracting, multiplying or dividing them. The apparatus shown in Fig. 1 unpacks only one such vector. For processing two vectors, the apparatus of Fig. 1 is duplicated.

A typical vector has a number of operands in a specific order such as $A_0$, $A_1$, $A_2$, $A_3$..., $A_n$. A sparse vector is a vector having certain predetermined operand values deleted. Normally, operands having a value of 0 or near 0 are deleted. The remaining operands are concatenated or packed for more efficient storage in memory and retrieval therefrom. For example, assume operands $A_2$, $A_3$ and $A_8$ of a given vector have the value of zero. The sparse vector of that vector would appear in memory as $A_1$, $A_4$, $A_5$, $A_6$, $A_7$, $A_9$,... $A_n$.

When performing an arithmetic operation with vectors, the corresponding order of operands of each vector must normally be simultaneously input to the ALU for processing. For example, when adding vector A to vector B, the corresponding order operands must be added, e.g. $A_1 + B_1$, $A_2 + B_2$, $A_3 + B_3$,... $A_n + B_n$.

As the sparse vectors located in memory do not have any inherent alignment information, i.e., the counting of five operands in from the first operand does not indicate operand $A_4$, each sparse vector must be provided with a corresponding order vector. An order vector consists essentially of a series of bits, one bit for each operand of a normal unpacked vector. The state of the bit is either zero or one. Zero indicates that the correspondingly ordered operand of the vector is deleted. One indicates that the correspondingly ordered operand of the vector is present. Only those operands corresponding to the one-bits, therefore, will be actually stored in memory.

In the prior art, such as with US—A—3 919 534, the order vector is inspected essentially one bit at a time. When a one-bit is encountered, the operand first in line is forwarded to the ALU for processing. But when a zero bit is encountered, an operand is not forwarded. With two vectors being simultaneously coprocessed, a one-bit in either order vector causes the forwarding of at least the operand from the sparse vector in which the order vector has a one-bit. If the other order vector has a zero-bit, a zero valued operand is inserted and forwarded instead of the operand at the head of the line.

The apparatus of Fig. 1 modifies this procedure by inspecting a group of eight order bits at a time. (In this regard, eight is an arbitrary number: as will be appreciated any desired number of bits inspected can be chosen.) Operands of a preselected value, such as zero are inserted into the operand stream coming from memory according to the occurrence of zeros in the order vector. The resulting expanded or unpacked eight operands are forwarded in parallel to the ALU for simultaneous tandem processing. An ALU such as found in the CDC CYBER 205 has the capability of processing eight operands in tandem.

If every bit of the order vector is a one signifying that eight non-zero operands are to be forwarded to the ALU, an increase in speed of up to eight times is achieved over the prior art method of forwarding one operand at a time to the ALU.

Sparse vector operands are fetched from memory by apparatus (not shown) and forwarded through interconnected eight-operand registers R1, R2, R3, respectively, such that operands $A_0$ to $A_7$ (assuming in this example that the sparse vector has no zero valued operands) are located in the register $R_3$, $A_8$ to $A_{15}$ in the register R2 and $A_{16}$ to $A_{23}$ in the register R1.

As the sparse vector operands are being loaded into the registers R1, R2, R3, the corresponding order vector of the sparse vector is loaded eight bits at a time into a register X0. Each machine cycle, eight more bits are loaded into the register X0 until all order vector bits have been loaded. Likewise, each machine cycle the contents of the register X0 are copied by an interconnected register X2 and also are provided as an input to a one-bit population counter EP1. The results of the population count, which may range from a count of 0 to a count of 8, are loaded into a four-bit register X1 during the same machine cycle.

On the third machine cycle, the contents of the register X2 are loaded into an interconnected register X3. The four-bit count of the register X1 is provided as one input to an adder A1. The other input to the adder A1 is provided by three bits from a register SC1, which is initialized to a starting shift count determined by a programmer. A bias of 0 is provided as the fourth bit to the adder A1. The three-bit output of the adder A1 is loaded into the register SC1 during the machine cycle. Also, a carry bit is loaded into a carry register C1. The three-bit limitation on the output of the adder A1 provides that any addition having a result higher than the number seven has a carry input to the carry register C1. The lower order three bits of a resultant are fed to the register SC1. Also during this machine cycle, an interconnected register SC2 copies the contents of the register SC1.

At the end of three machine cycles, the register X3 contains the first group of eight bits of the order vector; the register SC1 has the three bit count of the number of 1 bits in that first group of order-vector bits plus the starting shift count, and the register SC2 contains the starting shift count.

On the fourth machine cycle, the eight bits of the register X3 are provided as inputs to an expansion network E1. Also provided as inputs are eight outputs of a shift network 10. The shift network receives fifteen operands: eight from the register R3 and seven from the register R2. It shifts these operands to its eight outputs according to the count in the register SC2, which on the fourth machine cycle contains the starting shift count. The expansion network E1 also receives preset data operands, normally a value of zero, from the preset data line. The expansion network arranges the two sets of operand inputs according to the arrangement of order vector bits contained in the register X3.

For example, assume the starting shift count is zero and the initial eight bits of the order vector are 10011011, the leftmost bit corresponding to $A_0$. The register R3 then contains in its lowest ordered cells sparse vector operands as follows:

$$A_0, \quad A_3, \quad A_4, \quad A_6, \quad A_7$$
$$R3_0, \quad R3_1, \quad R3_2, \quad R3_3, \quad R3_4.$$

The expansion network E1 inspects the lowest order bit from the order vector bits in the register X3 and, finding it to be a one, places the operand $A_0$ from the register R3 on its lowest order output. It inspects the next highest order bit from the register X3 and, finding it to be a zero, places a preset data operand (0) on the second lowest order output, and so on, until the eight outputs of the expansion network are as follows:

$$A_0, \quad 0, \quad 0, \quad A_3, \quad A_4, \quad 0, \quad A_6, \quad A_7.$$

These eight outputs are still simultaneously provided as inputs to the ALU for tandem processing.

During the next machine cycle, the fifth, the contents of the register SC1, which is the count of the number of one-bits in the first group of eight order-vector bits, is loaded into the register SC2. The output of the register SC2 causes the shift network 10 to point, for example, to cell address 5 of the register R3 in which the number of one-bits in the first group or order-vector bits is five. By "point to", it is meant that the shift network shifts cells 5, 6, 7 of the register R3 and cells 0, 1, 2, 3, 4 of the register R2 into its eight outputs.

The second group of eight order bits is copied during this same machine cycle into the register X3. Assuming the second group of order vector bits contains the following pattern: 01011101, the operands present in the shift network outputs (in part) will have originated from the fifth order cell of the register R3 to the second order cell of the register R2 as follows:

$$A_9, \quad A_{11}, \quad A_{12}, \quad A_{13}, \quad A_{15}$$
$$R3_5, \quad R3_6, \quad R3_7, \quad R2_0, \quad R2_1.$$

The expansion network E1 places these five operands on its outputs according to the pattern of order vector bits in the register X3: 01011101. Thus the outputs of the expansion network at the end of the fifth cycle will be 0, $A_9$, 0, $A_{11}$, $A_{12}$, $A_{13}$, 0, $A_{15}$. These eight operands are forwarded in parallel for tandem coprocessing by the ALU.

The contents of the register SC1 in the previous machine cycle, cycle number four, was the number five reflective of five one-bits present in the first group of order vector bits. In addition to this count being loaded into the register SC2 for control of the shift network 10, it is also fed back as an input to the adder A1, as explained *supra*. The second group of order-vector bits also had five one-bits. Thus the population counter EP1 will have forwarded a count of five to the first input of the adder A1. The addition of these two count-of-five inputs causes the adder to place on its output the number 2 with a carry. The three lower most order bits have a bit-pattern 010 and are forwarded to the register SC1. The carry is forwarded to the carry register C1.

During the fifth machine cycle, the presence of a 1 bit in the carry register causes the register R3 to copy the contents of the register R2, the register R2 to copy the contents of the register R1 and the register R1 to load a new group of eight sparse vector operands.

Assuming the third and fourth groups of order vector bits are all ones, the contents of the register R3, R2, after this move, will appear as follows:

$$A_{13}, A_{15}, A_{16} \ldots A_{29}$$
$$R3_0, R3_1, R3_2, \ldots R2_7.$$

During this same machine cycle the contents of the register SC1 010, is loaded into the register SC2. During the next machine cycle the shift network 10 will thus point to cell $R3_2$, the second lowest order cell of register R3, which correctly contains the next sparse vector operand $A_{16}$ to be processed.

The process continues as such until each operand of the sparse vector has been forwarded to the ALU.

In more detail, if the order vector inputs to the expansion network E1 are denoted by $Z_0$, $Z_1 \ldots Z_n$, the eight operand inputs from the shift network 10 denoted by $A_0, A_1, \ldots A_n$, the outputs of the expansion network denoted by $O_0, O_1, \ldots O_n$, and B = preset data, the following logic equations describe the operation of the expansion network E1.

$$C_{00} = A_0\bar{Z}_0 + A_1Z_0$$
$$C_{10} = A_1\bar{Z}_0 + A_2Z_0$$
$$C_{20} = A_2\bar{Z}_0 + A_3Z_0$$
$$C_{30} = A_3\bar{Z}_0 + A_4Z_0$$
$$C_{40} = A_4\bar{Z}_0 + A_5Z_0$$
$$C_{50} = A_5\bar{Z}_0 + A_6Z_0$$
$$C_{60} = A_6Z_0 + A_7Z_0$$

$$C_{01} = C_{00}\bar{Z}_1 + C_{10}Z_1$$
$$C_{11} = C_{10}\bar{Z}_1 + C_{20}Z_1$$
$$C_{21} = C_{20}\bar{Z}_1 + C_{30}Z_1$$
$$C_{31} = C_{30}\bar{Z}_1 + C_{40}Z_1$$
$$C_{41} = C_{40}\bar{Z}_1 + C_{50}Z_1$$
$$C_{51} = C_{50}\bar{Z}_1 + C_{60}Z_1$$

$$C_{02} = C_{01}\bar{Z}_2 + C_{11}Z_2$$
$$C_{12} = C_{11}\bar{Z}_2 + C_{21}Z_2$$
$$C_{22} = C_{21}\bar{Z}_2 + C_{31}Z_2$$
$$C_{32} = C_{31}\bar{Z}_2 + C_{41}Z_2$$
$$C_{42} = C_{41}\bar{Z}_2 + C_{51}\bar{Z}_2$$

$$C_{03} = C_{02}\bar{Z}_3 + C_{12}Z_3$$
$$C_{13} = C_{12}\bar{Z}_3 + C_{22}Z_3$$
$$C_{23} = C_{22}\bar{Z}_3 + C_{32}Z_3$$
$$C_{33} = C_{32}\bar{Z}_3 + C_{42}Z_3$$

$$C_{04} = C_{03}\bar{Z}_4 + C_{13}Z_4$$
$$C_{14} = C_{13}\bar{Z}_4 + C_{23}Z_4$$
$$C_{24} = C_{23}\bar{Z}_4 + C_{33}Z_4$$

$$C_{05} = C_{04}\bar{Z}_5 + C_{14}Z_5$$
$$C_{15} = C_{14}\bar{Z}_5 + C_{24}Z_5$$

$$C_{06} = C_{05}\bar{Z}_6 + C_{15}Z_6$$

$$O_0 = B\bar{Z}_0 + A_0Z_0$$
$$O_1 = B\bar{Z}_1 + C_{00}Z_1$$
$$O_2 = B\bar{Z}_2 + C_{01}Z_2$$
$$O_3 = B\bar{Z}_3 + C_{02}Z_3$$
$$O_4 = B\bar{Z}_4 + C_{03}Z_4$$
$$O_5 = B\bar{Z}_5 + C_{04}Z_5$$
$$O_6 = B\bar{Z}_6 + C_{05}Z_6$$
$$O_7 = B\bar{Z}_7 + C_{06}Z_7$$

It will be appreciated that the above logic equations may best be implemented bit by bit on the respective operands A and B.

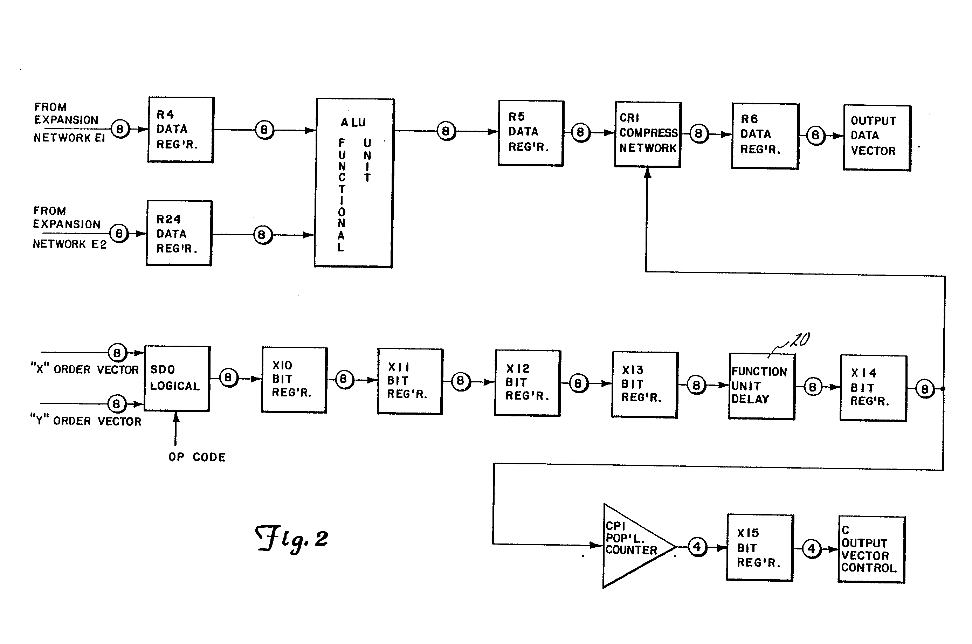

The ALU receives the operands $n$ pairs at a time and performs $n$ arithmetic or logic operations thereon in tandem. After having performed these functions, the ALU outputs n resultants per machine cycle. Some of those resultants may have a value of zero or an invalid result in the case of a divide by zero. It is desirable to store these resultants in memory with the zero or invalid resultants deleted. The apparatus for performing such deletions in a data processing apparatus according to the present invention is illustrated in Figure 2.

Each machine cycle operands from a first expanded vector are stored in a n-operand register R4. Likewise operands from a second expanded vector are stored in a $n$-operand register R24. The ALU loads the operands from these registers, performs $n$ tandem logical or arithmetic operations thereon and stores the n resultants in a $n$-resultant register R5. These $n$ resultants are then compressed into sparse vector format during the next machine cycle by a compress network CR1, which will be described more fully hereinafter. The compressed resultants are stored in a register R6. The number of resultants stored in the register R6 depends on the number of valid resultants (zero or invalid resultants deleted) present in the group of $n$ resultants. These resultants are then forwarded to memory *via* downstream apparatus (not shown).

The determination of which resultants are valid and which are zero or invalid is made according to a logical combination of the order vectors for the two sparse vectors, one of which is labeled the X order vector and the other of which is labeled the Y order vector. For example, if the operation to be performed on the two sparse vectors is an add or a subtract operation, the resultant vector will have a valid resultant for a given order whenever one of the input vectors had a valid operand in that order. If order vector X comprises 10000110 and order vector Y comprises 01001010, a resultant order vector Z will appear 11001110, a one corresponding to a valid resultant. This Z order vector is the logical "OR" of the X and Y order vectors. Likewise, if the operation is a multiply or a divide, the resultant order vector Z would appear 00000010, which is the logical "AND" of the X and Y order vector. Similar logical manipulation may be performed on the X and Y order vector to find a resultant order vector for any logical or arithmetic operation performed by the ALU.

In Fig. 2, this logical operation is performed in a block SDO, which has, as inputs, the two operand order vectors X and Y, as well as an indication of the function or op-code to be performed by the ALU. The block SDO receives the two order vectors, eight bits each machine cycle, and stores the results in a register X10.

The registers X10 to X13 are delay registers which delay the resultant order vector Z the number of machine cycles as the input sparse vector operands need to pass through the registers R1, R2, R3, R4.

The output from the register X13 is stored in a register X14, but, as the transfer between these two registers occurs during the same period of time the operands are being processed by the ALU, the transfer is delayed by a functional unit delay 20 to synchronize the arrival of Z order vector bits in the register X14 with the arrival of resultants in the register R5. The time of the delay depends upon the logical or arithmetic operation being performed by the ALU.

The contents of the register X14 are provided as one input to the compress network CR1 and also as the input to a population counter CP1, which counts the number of one bits therein. This count, representative of the number of valid operands in the register R5, is forwarded to a four-bit register X15, the output of which is provided to downstream circuitry to indicate the number of valid sparse vector resultants that are available in the register R6 for storage in memory.

The operation of the compress network CR1 is illustrated by the following example. Assuming the resultant order vector Z from the register R4 comprises the bit pattern 10101101, the resultants present in register R5, namely, $r_0$, $r_1$, $r_2$... $r_8$ will be compressed and stored, left justified, into the register R6 as follows: $r_0$, $r_2$, $r_4$, $r_5$, $r_7$, O, O, O, $r_1$, $r_3$ and $r_6$, which correspond to zeros in the Z order vector, having been deleted.

The logic equations for the compress network CR1, where $Z_0$ to $Z_7$ represent resultant order vector bits input from the register X14, $A_0$, $A_1$, $A_2$,... $A_7$ represent resultants input from the register R5 and $r_0$, $r_1$, $r_2$... $r_7$ represent the output of the compress network CR1, comprise the following:

$$C_{70} = A_7 Z_7$$
$$C_{60} = A_6 Z_6$$
$$C_{50} = A_5 Z_5$$
$$C_{40} = Z_4 Z_4$$
$$C_{30} = A_3 Z_3$$
$$C_{20} = A_2 Z_2$$
$$C_{10} = A_1 Z_1$$
$$C_{00} = Z_0 Z_0$$

$$C_{71} = C_{70} \overline{Z}_6$$
$$C_{61} = C_{70} Z_6 + C_{60}$$

$$C_{72} = C_{71} \overline{Z}_5$$
$$C_{62} = C_{71} \overline{Z}_5 + C_{61} Z_5$$
$$C_{52} = C_{61} Z_5 + C_{50}$$

$$C_{73} = C_{72} \overline{Z}_4$$
$$C_{63} = C_{72} \overline{Z}_4 + C_{62} Z_4$$
$$C_{53} = C_{62} \overline{Z}_4 + C_{52} Z_4$$
$$C_{43} = C_{52} Z_4 + C_{40}$$

$$C_{74} = C_{73} \overline{Z}_3$$
$$C_{64} = C_{73} \overline{Z}_3 + C_{63} Z_3$$
$$C_{54} = C_{63} \overline{Z}_3 + C_{53} Z_3$$
$$C_{44} = C_{53} \overline{Z}_3 + C_{43} Z_3$$
$$C_{34} = C_{43} Z_3 + C_{30}$$

$$C_{75} = C_{74} \overline{Z}_2$$
$$C_{65} = C_{74} \overline{Z}_2 + C_{64} Z_2$$
$$C_{55} = C_{64} \overline{Z}_2 + C_{54} Z_2$$
$$C_{45} = C_{54} \overline{Z}_2 + C_{44} Z_2$$
$$C_{35} = C_{44} \overline{Z}_2 + C_{34} Z_2$$
$$C_{25} = C_{34} Z_2 + C_{20}$$

$$C_{76} = C_{75} \overline{Z}_1$$
$$C_{66} = C_{75} \overline{Z}_1 + C_{65} Z_1$$
$$C_{56} = C_{65} \overline{Z}_1 + C_{55} Z_1$$
$$C_{46} = C_{55} \overline{Z}_1 + C_{45} Z_1$$
$$C_{36} = C_{45} \overline{Z}_1 + C_{35} Z_1$$
$$C_{26} = C_{35} \overline{Z}_1 + C_{25} Z_1$$
$$C_{16} = C_{25} Z_1 + C_{10}$$

$$r_7 = C_{77} = C_{76} \overline{Z}_0$$
$$r_6 = C_{67} = C_{76} \overline{Z}_0 + C_{66} Z_0$$
$$r_5 = C_{57} = C_{66} \overline{Z}_0 + C_{56} Z_0$$
$$r_4 = C_{47} = C_{56} \overline{Z}_0 + C_{46} Z_0$$
$$r_3 = C_{37} = C_{46} \overline{Z}_0 + C_{36} Z_0$$
$$r_2 = C_{27} = C_{36} \overline{Z}_0 + C_{26} Z_0$$
$$r_1 = C_{17} = C_{26} \overline{Z}_0 + C_{16} Z_0$$
$$r_0 = C_{07} = C_{16} Z_0 + C_{00}$$

The above sets of equations imply the use of two-way OR's. The preferred embodiment actually uses four-way OR's. Those skilled in the art should modify the above equations when implementing the logic with four-way OR's to produce equivalent four-way OR logic.

While not illustrated, it will be appreciated that a substitution of one-bits for the Z order vector bits will result in every resultant in the register R5 being transferred undisturbed to the register R6 and thence to memory. The resultant vector stored in memory under these circumstances would be in the expanded, uncompressed format. These one-bits may conveniently be introduced at the register X10. If only one sparse vector is introduced and the ALU op-code is a NO—OP, the net result is that a sparse vector is converted to an expanded vector.

Likewise, if the vector or vectors in memory to be processed by the ALU are already in their expanded format (and may be not even possessing an order vector), a group of one-bits input to the register $X_0$ of Fig. 1 in lieu of the order vector bits results in no expansion in the counter EP1. In this manner, an expanded vector or vectors may be processed and compressed. If only one is input and the ALU op-code is a NO—OP, the net result is that the expanded vector is compressed into a sparse vector.

If one bits are substituted at both registers X0 and X10, one or more expanded vectors may be processed.

## Claims

1. Data processing apparatus having an arithmetic logic unit for processing at least one predetermined number of operands in tandem and to process sparse vectors having corresponding order vectors; first register means (X0, X2, X3) for fetching order vector bits group by group until all order vector bits have been fetched; and means (E1) for aligning and ordering forwarded operands according to the alignment and order of the order vector bits, and to forward said aligned and ordered operands in tandem to the arithmetic logic unit, characterised by a one-bit counter (EP1) responsive to said first register means (X0, X2, X3) for developing a population count of the number of bits in a group of order vector bits; a second register means (R2) for loading, holding and outputting on outputs said predetermined number of operands; a third register means (R3) for loading, holding and outputting on outputs said predetermined number of operands; a shift network means (10) for shifting a number of consecutively ordered inputs to an equal number of outputs from a group of ordered inputs comprising in the lowest order the outputs of said second register means (R2) and in the highest order at least all but the highest order of the outputs of the said third register means (R3), the lowest order input to be shifted indicated by a shift count input, expansion means responsive to said first register means (X0, X2, X3) and said shifted outputs for ordering said shifted outputs according to the order of said order vector bits in said first register means, the ordered shifted outputs comprising the forwarded operands; shift count register means (SC1) for holding and outputting on outputs a shift count, the outputs having means for interconnection to a shift count input of said shift network means; adder means (A1) for adding together said population count and the shift count present in said shift count register means to form on a first adder output the lowest order bits of said sum, the maximum count of which is one less than said predetermined number, and on a second adder output a carry when said sum equals or exceeds said predetermined number; means (SC2) for moving said first adder output into said shift count register means after said aligned and ordered operands have been forwarded to the arithmetic logic unit; and means (C1) interconnected to said second adder output for moving in response to the presence of a carry the operands present in said third register means (R3) into said second register means (R2) and for loading a new group of said predetermined number of sparse vector operands into said second register means.

2. Apparatus as claimed in claim 1 characterised in that said order vector bits comprise bits of two types: a first type (one bits) indicative of the location of sparse vector operands in an expanded vector and a second type (zero bits) indicative of the location of operands of a preselected value in the expanded vector; and further characterised in that said one bit counter is adapted to count the number of bits of said first type (one bits) in a group of order vector bits and that said expansion means is adapted to order the shifted outputs according to the order of said first type of order vector bits.

3. Apparatus as claimed in claim 2 characterised in that said expansion means includes means for inserting and forwarding operands of a preselected value according to the order of said second type of order vector bits (zero bits) in said first register means.

4. Apparatus as claimed in claim 2 or 3 characterised by including means (SDO) for forming an output order vector comprising the logical "OR", in the case of an add or a subtract arithmetic logic unit operation, or for forming the logical "AND", in the case of a multiply or a divide operation, of the order vectors corresponding to the sparse vectors added, subtracted, multiplied or divided by the arithmetic logic unit; means (CP1) for developing a count of the number of bits in a group of said output order vector bits indicative of the presence of valid sparse vector resultants in the output of said arithmetic logic unit, the total number of bits in said group being equal to said predetermined number of operands said arithmetic logic unit is capable of processing in tandem; means (R5) for receiving an output of said predetermined number of resultants from said arithmetic logic unit and for extracting those resultants aligned and ordered according to the alignment and order of said output order vector bits indicative of valid sparse vector resultants; and means for forwarding said extracted resultants to an output, the number forwarded being equal to said count.

5. Apparatus as claimed in claim 4 characterised by including means (CR1) for selectively substituting all one bits in lieu of either said order vector bits or said output order vector bits, or both whereby expanded format vectors may be selectively input to, output from or both input to and output from said tandem processing arithmetic logic unit.

**Patentansprüche**

1. Datenverarbeitungsgerät mit einem Rechenwerk zur Verarbeitung von zumindest einer vorgegebenen Anzahl von Operanden in Tandem und zur Verarbeitung von "sparse vectors", die entsprechende Ordnungsvektoren aufweisen, mit ersten Registereinrichtungen (XO, X2, X3) zur Aufnahme von Ordnungsvektor-Bits Gruppe für Gruppe, bis alle Ordnungsvektor-Bits aufgenommen wurden, und mit Einrichtungen (E1) zur Ausrichtung und Ordnung von zugeführten Operanden entsprechend der Ausrichtung und Ordnung der Ordnungsvektor-Bits und zur Zuführung der ausgerichteten und geordneten Operanden in Tandem an das Rechenwerk, gekennzeichnet durch einen auf die ersten Registereinrichtungen (XO, X2, X3) ansprechenden EINS-Bit-Zähler (EP1) zur Erzeugung einer Populationszählung der Anzahl von Bits in einer Gruppe von Ordnungsvektor-Bits, eine zweite Registereinrichtung (R2) zum Laden, Halten und Ausgeben der vorgegebenen Anzahl von Operanden an Ausgängen, eine dritte Registereinrichtung (R3) zum Laden, Halten und Ausgeben der vorgegebenen Anzahl von Operanden an Ausgängen, eine Schiebe-Netzwerkeinrichtung (10) zum Verschieben einer Anzahl von aufeinanderfolgend angeordneten Eingängen an eine gleiche Anzahl von Ausgängen aus einer Gruppe von geordneten Eingängen, die in der niedrigsten Ordnung die Ausgänge der zweiten Registereinrichtungen (R2) und in der höchsten Ordnung zumindest alle Ausgänge, mit Ausnahme des Ausganges höchster Ordnung, der dritten Registereinrichtung (R3) umfassen, wobei der Eingang niedrigster Ordnung, der zu verschieben ist, durch einen Schiebe-Zähleingang angezeigt ist, Erweiterungseinrichtungen, die auf die erste Registereinrichtung (XO, X2, X3) und die verschobenen Ausgänge ansprechen, um die verschobenen Ausgänge entsprechend der Ordnung der Ordnungsvektor-Bits in der ersten Registereinrichtung zu ordnen, wobei die geordneten verschobenen Ausgänge die zugeführten Operanden umfassen, Schiebezähl-Registereinrichtungen (SC1) zum Halten und Ausgeben einer Schiebezählung an Ausgängen, wobei die Ausgänge Einrichtungen zur Verbindung mit einem Schiebezähleingang der Schiebe-Netzwerkeinrichtung aufweisen, Addiereinrichtungen (A1) zum Addieren der Populationszählung und der Schiebezählung, die in der Schiebezähl-Registereinrichtung vorhanden ist, um an einem ersten Addierer-Ausgang die Bits niedrigster Ordnung der Summe zu bilden, wobei die maximale Zählung hiervon um Eins kleiner ist als die vorgegebene Anzahl, und um an einem zweiten Addierer-Ausgang einen Übertrag zu bilden, wenn die Summe gleich oder größer als die vorgegebene Anzahl ist, Einrichtungen (SC2) zum Bewegen des ersten Addierer-Ausgangs in die Schiebezähl-Registereinrichtung, nachdem die ausgerichteten und geordneten Operanden dem Rechenwerk zugeführt wurden, und mit dem zweiten Addierer-Ausgang verbundene Einrichtungen (C1), die in Abhängigkeit von dem Vorhandensein eines Übertrags die in der dritten Registereinrichtung (R3) vorhandenen Operanden in die zweite Registereinrichtung (R2) bewegen und eine neue Gruppe der vorgegebenen Anzahl von Sparse-Vektor-Operanden in die zweite Registereinrichtung laden.

2. Datenverarbeitungsgerät nach Anspruch 1, dadurch gekennzeichnet, daß die Ordnungsvektor-Bits Bits von zwei Typen umfassen: einen ersten Typ (EINS-Bits), der die Lage von Sparse-Vektor-Operanden in einem erweiterten Vektor anzeigt, und einen zweiten Typ (NULL-Bits), der die Lage von Operanden eines vorausgewählten Wertes in dem erweiterten Vektor anzeigt, und daß der EINS-Bit-Zähler die Anzahl von Bits des ersten Typs (EINS-Bits) in einer Gruppe von ordnungsvektor-Bits zählt, und daß die Erweiterungseinrichtungen zum Ordnen der verschobenen Ausgänge entsprechend der Ordnung der Ordnungsvektor-Bits vom ersten Typ ausgebildet sind.

3. Datenverarbeitungsgerät nach Anspruch 2, dadurch gekennzeichnet, daß die Erweiterungseinrichtungen Einrichtungen zum Einsetzen und Zuführen von Operanden eines vorausgewählten Wertes entsprechend der Ordnung des zweiten Typs von Ordnungsvektor-Bits (NULL-Bits) in die erste Registereinrichtung einschließen.

4. Datenverarbeitungsgerät nach Anspruch 2 oder 3, gekennzeichnet durch den Einschluß von Einrichtungen (SDO) zur Bildung eines Ausgangs-Ordnungsvektors, der im Fall einer Addier- oder einer Subtrahier-Rechenwerkoperation die logische ODER-Verknüpfung oder im Fall einer Multiplizier- oder Dividier-Operation die logische UND-Verknüpfung der Ordnungsvektoren bildet, die den in dem Rechenwerk addierten, subtrahierten, multiplizierten oder dividierten Sparse-Vektoren entsprechen, von Einrichtungen (CP1) zur Erzeugung einer Zählung der Anzahl von Bits in einer Gruppe der Ausgangs-Ordnungsvektor-Bits, die das Vorhandensein von gültigen Sparse-Vektor-Resultierenden am Ausgang des Rechenwerkes anzeigen, wobei die Gesamtzahl von Bits in dieser Gruppe gleich der vorgegebenen Anzahl von Operanden ist, die das Rechenwerk in Tandem verarbeiten kann, von Einrichtungen (R5) zum Empfang eines Ausganges der vorgegebenen Anzahl von Resultierenden von dem Rechenwerk und zum Extrahieren der Resultierenden, die entsprechend der Ausrichtung und Ordnung der Ausgangs-Ordnungsvektor-Bits ausgerichtet und geordnet sind, die gültige Sparse-Vektor-Resultierende darstellen, und von Einrichtungen zur Zuführung der extrahierten Resultierenden an einen Ausgang, wobei die zugeführte Anzahl gleich der Zählung ist.

5. Datenverarbeitungsgerät nach Anspruch 4, gekennzeichnet durch Einrichtungen (CR1) zum selektiven Ersetzen aller Ordnungsvektor-Bits und/oder Ausgangs-Ordnungsvektor-Bits durch EINS-Bits, so daß ein erweitertes Format aufweisende Vektoren selektiv in das eine Tandem-Verarbeitung ermöglichende Rechenwrek eingegeben, von diesem ausgegeben oder sowohl in dieses eingegeben als auch aus diesem ausgegeben werden können.

## Revendications

1. Appareil de traitement de données comportant une unité arithmétique et logique pour traiter au moins un nombre prédéterminé d'opérandes en tandem et pour traiter des vecteurs épars comportant des vecteurs d'ordre correspondants; des premiers moyens à registre (X0, X2, X3) destinés à extraire des bits de vecteur d'ordre groupe par groupe jusqu'à ce que tous les bits de vecteur d'ordre soient extraits; et un moyen (E1) destiné à aligner et ordonner des opérandes ayant progressé en avant conformément à l'alignement et à l'ordre des bits de vecteur d'ordre, et à faire progresser en avant lesdits opérandes en tandem alignés et ordonnés jusqu'à l'unité arithmétique et logique, caractérisé en ce qu'il comprend un compteur de bits à un (EP1) destiné à répondre auxdits premiers moyens à registre (X0, X2, X3) pour calculer un compte de population du nombre de bits dans un groupe de bits de vecteur d'ordre; des deuxièmes moyens à registre (R2) destinés à charger, contenir et sortir à des sorties ledit nombre prédéterminé d'opérandes; des troisièmes moyens à registre (R3) destinés à charger, contenir et sortir à des sorties le nombre prédéterminé d'opérandes; un moyen à réseau de décalage (10) destiné à décaler un certain nombre de signaux d'entrée ordonnés consécutivement jusqu'à un nombre égal de sorties à partir d'un groupe d'entrées ordonnées comprenant dans l'ordre le plus bas les signaux de sortie des deuxièmes moyens à registre (R2) et dans l'ordre le plus élevé au moins presque l'ordre le plus élevé des signaux de sortie des troisièmes moyens à registre (R3), le signal d'entrée d'ordre le plus bas à décaler étant indiqué par un signal d'entrée de compte de décalage, un moyen d'extension destiné à répondre aux premiers moyens à registre (X0, X2, X3) et aux signaux de sortie décalés pour ordonner ces signaux de sortie décalés conformément à l'ordre des bits de vecteur d'ordre dans les premiers moyens à registre, les signaux de sortie décalés et ordonnés comprenant les opérandes ayant progressé en avant; un moyen à registre de compte de décalage (SC1) destiné à contenir et sortir à des sorties un compte de décalage, les sorties comportant des moyens pour établir une interconnexion avec une entrée de compte de décalage du moyen à réseau de décalage; un moyen additionneur (A1) destiné à additionner ensemble ledit compte de population et le compte de décalage présent dans le moyen à registre de compte de décalage pour former à une première sortie d'additionneur les bits d'ordre le plus bas de ladite somme dont le compte maximal est égal au nombre prédéterminé moins un, et à une deuxième sortie d'additionneur un report quand la somme égale ou dépasse le nombre prédéterminé; un moyen (SC2) destiné à envoyer le signal de première sortie d'additionneur dans le moyen à registre de compte de décalage après que les opérandes alignés et ordonnés ont progressé en avant jusqu'à l'unité arithmétique et logique; et un moyen (C1) interconnecté avec la deuxième sortie d'additionneur pour envoyer, un réponse à la présence d'un report, les opérandes présents dans les troisièmes moyens à registre (R3) dans les deuxièmes moyens à registre (R2) et pour charger un nouveau groupe du nombre prédéterminé d'opérandes de vecteurs épars dans les deuxièmes moyens à registre.

2. Appareil selon la revendication 1, caractérisé en ce que les bits de vecteur d'ordre comprennent des bits de deux types: un premier type (bits à un) indiquant l'emplacement d'opérandes de vecteurs épars dans un vecteur étendu et un deuxième type (bits à zéro) indiquant l'emplacement d'opérandes d'une valeur présélectionnée dans le vecteur étendu; et caractérisé en outre en ce que le compteur de bits à un est agencé pour compter le nombre de bits dudit premier type (bits à un) dans un groupe de bits de vecteur d'ordre et en ce que ledit moyen d'extension est agencé pour ordonner les signaux de sortie décalés conformément à l'ordre du premier type de bits de vecteur d'ordre.

3. Appareil selon la revendication 2, caractérisé en ce que le moyen d'extension comprend un moyen destiné à insérer et faire progresser en avant des opérandes d'une valeur présélectionnée conformément à l'ordre du deuxième type de bits de vecteur d'ordre (bits à zéro) dans les premiers moyens à registre.

4. Appareil selon l'une quelconque des revendications 2 et 3, caractérisé en ce qu'il comprend un moyen (SDO) destiné à former un vecteur d'ordre de sortie constituant la fonction logique "OU", dans le cas d'une opération d'unité arithmétique et logique d'addition ou de soustraction, ou à former la fonction logique "ET", dans le cas d'une opération de multiplication ou de division, des vecteurs d'ordre correspondant aux vecteurs épars additionnés, soustraits, multipliés ou divisés par l'unité arithmétique et logique; un moyen (CP1) destiné à calculer un compte du nombre de bits dans un groupe des bits de vecteur d'ordre de sortie indiquant la présence de signaux résultants de vecteurs épars valides à la sortie de l'unité arithmétique et logique, le nombre total de bits dans le groupe étant égal au nombre prédéterminé d'opérandes que l'unité arithmétique et logique est capable de traiter en tandem; un moyen (R5) destiné à recevoir le nombre prédéterminé de signaux résultants de sortie de l'unité arithmétique et logique et à extraire ces signaux résultants alignés et ordonnés conformément à l'alignement et à l'ordre des bits de vecteur d'ordre de sortie indiquant les signaux résultants de vecteurs épars valides; et un moyen destiné à faire progresser en avant les signaux résultants extraits jusqu'à une sortie, le nombre de signaux ayant progressé en avant étant égal audit compte.

5. Appareil selon la revendication 4, caractérisé en ce qu'il comprend un moyen (CR1) pour substituer sélectivement tous les bits à un remplacement des bits de vecteur d'ordre ou des bits de vecteur d'ordre de sortie, ou par lequel à la fois les vecteurs de format étendu peuvent être sélectivement entrés dans, sortis de ou à la fois entrés dans et sortis de l'unité arithmétique et logique de traitement en tandem.

Fig.1

Fig.2